Europäisches Patentamt

European Patent Office

Office européen des brevets

(11) Veröffentlichungsnummer: **0 227 898**
**A1**

# (12) EUROPÄISCHE PATENTANMELDUNG

(21) Anmeldenummer: 86114044.0

(22) Anmeldetag: 10.10.86

(51) Int. Cl.4: **G01N 24/04** , **G01N 24/08**

(30) Priorität: 22.10.85 DE 3537541

(43) Veröffentlichungstag der Anmeldung:
08.07.87 Patentblatt 87/28

(84) Benannte Vertragsstaaten:
**DE FR GB NL**

(71) Anmelder: **Siemens Aktiengesellschaft Berlin und München**
**Wittelsbacherplatz 2**
**D-8000 München 2(DE)**

(72) Erfinder: **Hartl, Winfried, Dr.**
**Im Heuschlag 25**
**D-8520 Erlangen(DE)**
Erfinder: **Oppelt, Arnulf, Dr.**
**Schwedenstrasse 25**
**D-8521 Spardorf(DE)**
Erfinder: **Sturm, Helmut, Dr.**
**Am Eichengarten 6**
**D-8520 Erlangen-Buckenhof(DE)**

(54) **Oberflächenspule für Untersuchungen mit Hilfe der kernmagnetischen Resonanz.**

(57) Die Erfindung betrifft eine flache Oberflächenspule (4) für spektroskopische in vivo-Untersuchungen eines Objektes (3) mit Hilfe der kernmagnetischen Resonanz. In der Spule (4), die bei einer Untersuchung auf das Objekt (3) aufgesetzt wird, befindet sich eine Eichsubstanz (8), welche ebenfalls ein von der Spule (4) meßbares Kernresonanzsignal liefert.

FIG 1

EP 0 227 898 A1

## Oberflächenspule für Untersuchungen mit Hilfe der kernmagnetischen Resonanz

Die Erfindung betrifft eine flache Oberflächenspule für spektroskopische in vivo-Untersuchungen eines Objektes mit Hilfe der kernmagnetischen Resonanz. Oberflächenspulen dieser Art werden bei der Rotating Frame-Spektroskopie benutzt und erzeugen in der Regel hochfrequente Felder, die nicht homogen sind. In dem Artikel "Journal of Magnetic Resonance", 60, Seiten 268 bis 279, ist beispielsweise eine Anwendung der Rotating Frame-Spektroskopie mit Hilfe von Oberflächenspulen beschrieben worden. Ein Untersuchungsobjekt befindet sich in einem homogenen magnetischen Grundfeld einer NMR-Anlage. Eine Oberflächenspule wird in der Nähe des zu untersuchenden Bereiches positioniert und regt mit Hilfe eines Hochfrequenzpulses bestimmter Leistung und mit einer bestimmten Pulsdauer $t$, über das magnetische Wechselfeld die Kernspins des Untersuchungsobjektes an. Das von den angeregten Spins ausgesandte Kernresonanzsignal wird von der Oberflächenspule aufgenommen und abgespeichert. Dieser Vorgang wird mit jeweils schrittweise veränderten Werten der Hochfrequenzleistung oder schrittweise veränderten Werten der Pulsdauer $t$, wiederholt. Eine zweidimensionale Fouriertransformation der gemessenen Werte ergibt schließlich eine Karte, auf der die spektrale Verteilung des Kernresonanzsignales in Abhängigkeit einer verallgemeinerten Ortskoordinate zu sehen ist. Diese verallgemeinerte Ortskoordinate ist gegeben durch die Komponente der Hochfrequenzfeldstärke senkrecht zur Richtung des magnetischen Grundfeldes, d.h., ein Teilspektrum der so ge wonnenen Karte zeigt die spektrale Verteilung des Signales derjenigen Spins, die sich auf einer Schale mit konstanter Feldstärkekomponente (bezogen auf eine Ebene senkrecht zum Grundfeld) befinden.

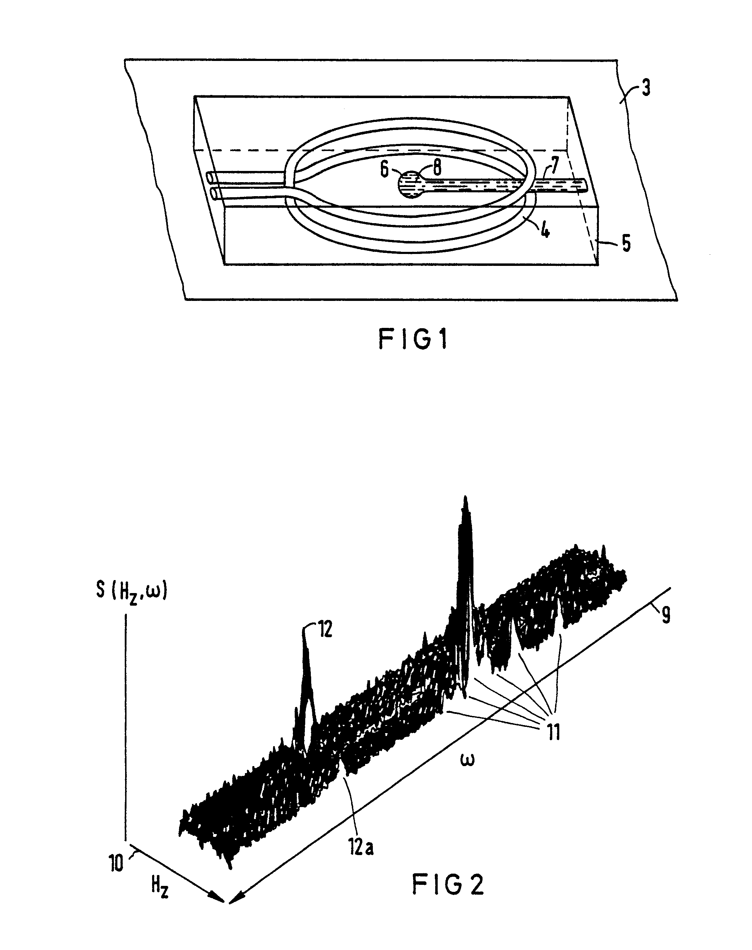

Die Figur 1 des Artikels in "Journal of Magnetic Resonance", 60, Seiten 268 bis 279, zeigt einen Schnitt, der die Feldcharakteristik bei einer einfachen Oberflächenspule verdeutlicht. Orte, die die gleiche Feldstärkekomponenten senkrecht zur Grundfeldrichtung besitzen, sind durch Kontur-Linien miteinander verbunden.

Ist die räumliche Verteilung des untersuchten Kernspinensembles von vornherein unbekannt, wie z.B. bei der Untersuchung von biologischen Proben oder in vivo-Untersuchungen, ist eine absolute Zuordnung der gemessenen Spektren zur entsprechenden Schale konstanter Hochfrequenzfeldstärke nicht möglich, auch wenn die genauere Hochfrequenzfeldverteilung der Spule, z.B. aufgrund von theoretischen Rechnungen oder Eichmessungen bekannt ist. Ursache hierfür ist die Bedämpfung der Spule durch das biologische Gewebe, die eine eindeutige Zuordnung eines Hochfrequenzpulses bestimmter Energie zu einem definierten Flipwinkel, um den die Kernspinmagnetisierung auf einer definierten Schale konstanter Hochfrequenzfeldstärke gekippt wird, verhindert. Beholfen hat man sich bisher, indem man bei der Darstellung der Spektren als Funktion der Ortskoordinate das erstmalige Auftauchen eines Spektrums mit der Objektoberfläche gleichsetzt.

Der Erfindung liegt die Aufgabe zugrunde, eine Oberflächenspule der oben beschriebenen Art so auszubilden, daß eine Zuordnung der von einem Objekt gemessenen Spektren zu je einer Schale konstanter Hochfrequenzfeldstärkekomponente - (bezogen auf eine Ebene senkrecht zum Grundfeld) möglich ist.

Die Aufgabe wird erfindungsgemäß dadurch gelöst, daß in der Oberflächenspule eine Eichsubstanz angeordnet ist, die ebenfalls durch die Hochfrequenzpulse angeregt wird und ein durch die Oberflächenspule meßbares Kernresonanzsignal aussendet.

Hierdurch ist eine eindeutige Kalibrierung des Flipwinkels als Funktion der Puls-Leistung bzw. - dauer bei jedem Meßobjekt möglich. Unter der Annahme, daß sich die Charakteristik der Hochfrequenzverteilung der Oberflächenspule durch das Meßobjekt nicht ändert, ist dann eine Zuordnung der von einem Objekt gemessenen Spektren zu je einer Schale konstanter Hochfrequenzfeldstärkekomponente mit einem bestimmten Abstand zur Oberflächenspule möglich. In den zweidimensionalen Meßspektren taucht dann immer die Linie (Peak) des Eichkörpers auf, deren Position eine Kalibrierung ermöglicht. Ein weiterer Vorteil ist, daß hiermit auch stets ein Standard für die chemische Verschiebung vorliegt. Wird die Eichsubstanz zusätzlich an Stellen angeordnet, an denen unterschiedliche Amplituden des von der Hochfrequenzspule erzeugten Feldes herrschen, erhält man nicht nur den bereits oben beschriebenen Peak entlang der Ortsachse entsprechend dem Ort der zentralen Punktprobe, sondern auch in allen anderen Spektren eine Linie der Eichprobe. Diese zusätzliche Phosphorlinie ist sehr nützlich bei der Phasenkorrektur von in vivo-Spektren. Die in die Oberflächenspule fest integrierte Eichprobe ermöglicht weiterhin eine einfache Überprüfung der Funktionstüchtigkeit der NMR-Anlage und eine Überprüfung des Shimzustandes.

Die Erfindung ist nachfolgend anhand eines Ausführungsbeispieles sowie der Figuren 1 und 2 näher erläutert. Es zeigen:

Fig. 1 eine Oberfächenspule mit Eichprobe nach der Erfindung, und

Fig. 2 die Spektralverteilungen, errechnet aus den gemessenen Signalen eines Untersuchungsobjektes nach der Methode des Rotating Frame-Verfahrens.

Die Figur 1 zeigt eine Ausführungsform der erfindungsgemäßen Oberflächenspule mit Eichprobe, aufgelegt auf einen Untersuchungskörper 3. Eine aus zwei Windungen bestehende Hochfrequenzspule 4 ist in ein Trägermaterial 5 eingebettet. Im Zentrum der Spule 4 befindet sich ein kleiner Rundkolben 6 aus Quarzglas mit einer bis an den Rand des Trägermaterials 5 reichenden Einfüllkapillare 7. Die Innenräume des Kolbens 6 und der Kapillare 7 sind mit der Eichsubstanz 8 aufgefüllt. Für die Phosphorspektroskopie eignet sich in besonderem Maße eine Substanz, die Methandiphosphorsäure, da aufgrund der großen chemischen Verschiebung dieses Stoffes die entsprechende Linie meist außerhalb der verschiedenen in vivo-Phosphorspektren liegt. Durch die in der Spulenebene liegende Einfüllkapillare 7 befindet sich die Eichsubstanz 8 in Bereichen mit unterschiedlichen Feldstärkekomponenten senkrecht zum magnetischen Grundfeld.

Eine mit dieser Oberflächenspule nach dem Rotating Frame-Verfahren erstellte Karte zeigt die Figur 2. Längs der Omega-Achse (Achse 9) ist jeweils für eine bestimmte Schale konstanter Feldstärkekomponente $H_z$ (Achse 10) die spektrale Verteilung $S(\omega)$ des Signales der Spins auf dieser Schale zu ersehen. Die Resonanzlinie 12 der Eichsubstanz 8 liegt weit entfernt von den Resonanzlinien 11 des untersuchten Objektes 3, so daß keine störende Beeinflussung der Spektren eintritt. Durch die Lage der Eich proben-Resonanzlinie 12 relativ zu den anderen Linien 11 hat man stets ein Maß für die chemische Verschiebung der im Untersuchungskörper nachgewiesenen Substanzen. Da sich die Eichsubstanz 8 in Bereichen unterschiedlicher Feldstärkekomponenten $H_z$ befindet, ist die Resonanzlinie 12 der Eichsubstanz ebenfalls in allen anderen Spektren vorhanden (12a).

**Ansprüche**

1. Oberflächenspule für die spektroskopische in vivo-Untersuchung eines Objektes (3) mit Hilfe der kernmagnetischen Resonanz, bestehend aus einer flachen Hochfrequenzspule (4), welche auf das Objekt (3) aufgesetzt wird, welche die Kernspins des Objektes (3) über hochfrequente, elektromagnetische Wellen anregt und das von ihnen ausgesandte Kernresonanzsignal empfängt, **dadurch gekennzeichnet**, daß sich in der Hochfrequenzspule (4) eine Eichsubstanz (8) befinet, die ebenfalls angeregt wird und ein durch die Hochfrequenzspule (4) meßbares Kernresonanzsignal aussendet.

2. Oberflächenspule nach Anspruch 1, **dadurch gekennzeichnet**, daß die Eichsubstanz (8) Methandiphosphorsäure enthält.

3. Oberflächenspule nach Anspruch 1 oder 2, **dadurch gekennzeichnet**, daß sich die Eichsubstanz (8) im Zentrum der Hochfrequenzspule (4) befindet.

4. Oberflächenspule nach einem der Ansprüche 1 bis 3, **dadurch gekennzeichnet**, daß sich die Eichsubstanz (8) zusätzlich an Stellen (7) befindet, an denen unterschiedliche Amplituden des von der Hochfrequenzspule (4) erzeugten Feldes herrschen.

FIG 1

$S(H_z, \omega)$

FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | NATURE, Band 283, 10. Januar 1980, Seiten 167-170, Macmillan Journals Ltd, Basingstoke, GB; J.J.H. ACKERMAN et al.: "Mapping of metabolites in whole animals by 31P NMR using surface coils" * Abschnitte: "Theory and design of surface coils" und "Experiments with phantoms" * --- | 1 | G 01 N 24/04 G 01 N 24/08 |
| Y | JOURNAL OF MAGNETIC RESONANCE, Band 55, 1983, Seiten 164-169, Academic Press, Inc., Orlando, FL, US; A. HAASE et al.: "Spatial localization of high resolution 31P spectra with a surface coil" * Gesamte Veröffentlichung * --- | 1,4 | |
| Y | EP-A-0 105 220 (SIEMENS AKTIENGESELLSCHAFT) * Seite 4, Zeile 11 - Seite 5, Zeile 27 * --- | 1,4 | RECHERCHIERTE SACHGEBIETE (Int. Cl.4) G 01 N |
| A | THE JOURNAL OF NUCLEAR MEDICINE, Band 25, Nr. 2, Februar 1984, Seiten 237-248, New York, US; C.T. BURT et al.: "Multinuclear NMR studies of naturally occurring nuclei" * Seiten 237-239,245,246 * --- -/- | 1 | |

Der vorliegende Recherchenbericht wurde für alle Patentansprüche erstellt.

| Recherchenort | Abschlußdatum der Recherche | Prüfer |
|---|---|---|
| DEN HAAG | 04-02-1987 | HORAK G.I. |

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int Cl.4) |
|---|---|---|---|
| A,D | JOURNAL OF MAGNETIC RESONANCE, Band 60, 1984, Seiten 268-279, Academic Press, Inc., Orlando, FL, US; M. GARWOOD et al.: "Spatial localization of tissue metabolites by phosphorus-31 NMR rotating-frame zeugmatography" * Gesamte Veröffentlichung *   --- | 1 | |
| A | EP-A-0 106 551 (PICKER INTERNATIONAL LIMITED) * Seite 2, Zeilen 1-28; Seite 4, Zeilen 15-32 *   --- | 1 | |
| A | GB-A-2 043 914 (EMI LIMITED) * Seite 1, Zeilen 4-20,88-110 *   --- | 1 | |
| A | US-A-3 501 688 (F.A. NELSON) * Spalte 1, Zeile 23 - Spalte 2, Zeile 5; Spalte 2, Zeile 29 - Spalte 3, Zeile 2 *   ----- | 1 | RECHERCHIERTE SACHGEBIETE (Int. Cl.4) |

Der vorliegende Recherchenbericht wurde für alle Patentansprüche erstellt.

| Recherchenort | Abschlußdatum der Recherche | Prüfer |
|---|---|---|
| DEN HAAG | 04-02-1987 | HORAK G.I. |